# EUROPEAN PATENT APPLICATION

(11) **EP 3 366 814 A1**
(43) Date of publication of application: **29.08.2018**
(21) Application number: 18000129.9
(22) Date of filing: 12.02.2018
(51) Int. Cl.: C25D 3/12, C25D 3/14, C25D 5/12, C25D 5/34, C25D 5/48, C25D 7/06, H01L 33/60, C25D 3/46, C25F 1/00, C23G 1/10

(54) **PROCESS FOR TREATING A METAL SURFACE AND OBTAINED FOIL**

(30) Priority: 27.02.2017 FR 1751567
(71) Applicant: Diehl Power Electronic S.A.S., 43300 Slaugues Sante Marie (FR)
(72) Inventor: Correia, Sandra, FR - 43370 Bains (FR); Delmas, Lionel, FR - 43000 Le Puy en Velay (FR); Antoine, Alexandre, FR - 43000 Le Puy en Velay (FR)
(74) Representative: Ecker, Irene Christiane Ingrid

(57) **Abstract**

The invention relates to a process for treating a metal surface, essentially comprising the following successive steps consisting in:
a) preparing the metal substrate (1') in order to make the surface apt to receive an electrodeposit;
b) producing at least one first nickel electrodeposit (2);
c) producing at least one second electrodeposit of at least one silver layer (4, 3).

Process characterized in that it consists in:
d) subjecting said metal surface coated with the nickel layer (2) and the one or more silver layers (4, 3) to at least one cleaning operation of chemical and/or electrolytic nature; and
in that the first and second electrodeposition operations are configured and parameterized to form a nickel layer (2) of at least 0.7 µm thickness and a silver layer (4, 3) of thickness comprised between 2 µm and 10 µm, respectively.

## Description

The present invention relates to the field of surface treatment, in particular surface treatment of metal surfaces, optionally containing plastic areas, or formed on plastic substrates via electrolytic coating techniques.

The invention more particularly relates to a treating process comprising a set of treating operations aiming to obtain a high-reflectance silver electrodeposit with good wiring or wire-bonding properties.

There is currently, in various technological fields, a high demand for metal surfaces having a high reflectance (of about 85% to 90%) in the wavelength domain of the blue of visible light (about 380 to 450 nm) and also having a good solderability (chip soldering) and a good wire bondability.

Such is in particular the case in the field of white light-emitting diodes (LEDs), which have advanced a lot recently.

In this context, the most common way of producing white light is to associate a semiconductor chip emitting in the blue with a yellow luminophore (phosphor).

In the case of white LEDs, the phosphor is excited by the blue light emitted by the chip on which it is placed. Certain blue photons generated in the LED pass through the luminophore without alteration; others interact with the phosphor and are converted into yellow photons. The combination of blue and yellow photons generates white light.

In order to optimize the performance of these diodes, it is necessary for a maximum of the light emitted by the chip to pass through the phosphor. In certain devices, the luminophore is wider than the chip, and therefore surrounds a portion of the substrate located below. For this reason, the surfaces under and around the chip must have a high reflectance with respect to blue light so as to have the lowest possible light absorption.

Lastly, in order to ensure a constant performance, it is necessary for the properties of the surfaces to be stable over time. The surfaces used must therefore be resistant to corrosion, exhibit no diffusion effects and resist temperature.

Among commonplace metals, those having the best reflectances with respect to blue light (450 nm) are silver and aluminium.

Those skilled in the art know that the reflectance of silver may be slightly higher than that of aluminium and that the latter metal in addition has the drawback of spontaneously forming a nonconductive oxide layer. Thus, a silver film is often used as reflective layer in the aforementioned type of LEDs.

Currently, most reflective silver deposits are produced using physical or chemical vapour deposition processes, because of the high uniformity of the metal surfaces thus obtained. However, these dry processes have long deposition times (discontinuous vacuum techniques with low deposition rates) and a high cost (substantial loss of material and expensive equipment).

The other common method for depositing silver films is electrodeposition. In the field of reflectance applications, various electro- and electroless processes exist (they are particularly suitable for what are called "spot" technologies) and have been implemented with some success.

Among known surface treatment processes allowing a silver electrodeposit to be obtained, certain comprise depositing, beforehand, a nickel layer by way of tie layer and above all as a barrier to the diffusion of copper (see for example US 2012/0061710 and US 8 062 765).

However, these known electro-processes do not allow a high reflectance (of about 85-90%) to be reliably obtained with respect to blue light, are relatively expensive to implement and do not systematically guarantee a final surface with good soldering and wire-bonding properties. In addition, they do not take into account effects related to the ageing of the product and therefore ensure good properties only for a short length of time.

The main aim of the invention is to provide a solution to at least some and preferably all of the aforementioned problems. In other words, the invention aims to provide an industrially economical process with an excellent yield and that allows a final product to be obtained that, over the long term, has a high reflectance with respect to blue light, is free from visual defects, exhibits no problem with diffusion of lower layers toward the surface, resists corrosion and heating and is apt to receive all sorts of connections.

To this end, one subject of the invention is a process for treating a metal surface, essentially comprising the following successive steps consisting in:
a) preparing the metal substrate in order to make the surface apt to receive an electrodeposit of at least one other metal, said surface preparation optionally being specifically suitable for receiving a nickel electrodeposit;
b) carrying out at least one first electrodeposition in order to coat at least one section of the metal surface with at least one nickel layer; and
c) carrying out at least one second electrodeposition in order to coat, at least partially, the section of metal surface provided with said nickel layer with at least one silver layer;
process characterized in that it consists in:
d) subjecting said metal surface coated with the nickel layer and the one or more silver layers to at least one cleaning operation of chemical and/or electrolytic nature, and optionally to a drying operation; and in that the first and second electrodeposition operations are configured and parameterized to form a nickel layer of at least 0.7 µm thickness and a silver layer of thickness comprised between 2 µm and 10 µm and preferably between 2 µm and 5 µm, respectively.

The invention will be better understood by virtue of the following description, which relates to one preferred embodiment that is given by way of nonlimiting example and described with reference to the appended drawings.

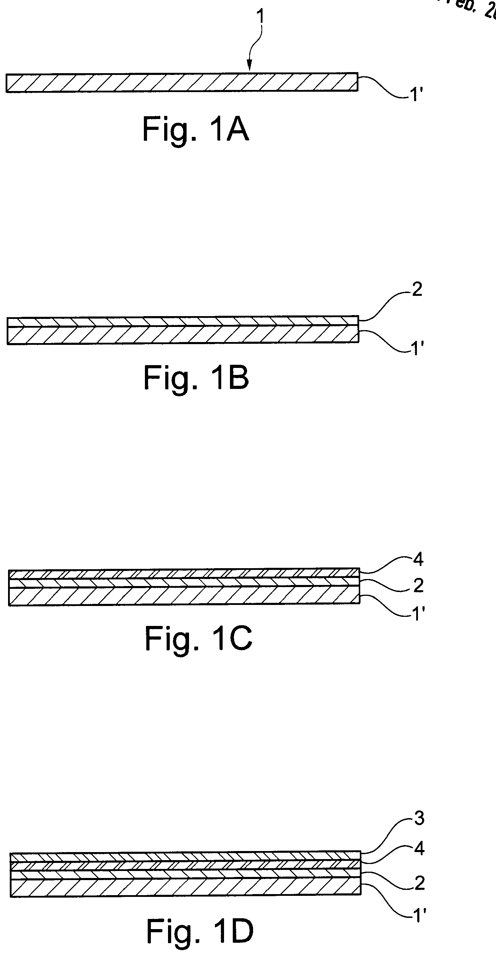

Figures 1A to 1D are schematic cross-sectional views illustrating the treated product in each of the processing steps of one preferred embodiment of the process of the invention.

The overall process for treating a metal surface essentially comprises the following successive steps consisting in:
a) preparing the metal substrate (1') in order to make the surface (1) apt to receive an electrodeposit of at least one other metal, said surface preparation optionally being specifically suitable for receiving a nickel electrodeposit;
b) carrying out at least one first electrodeposition in order to coat at least one section of the metal surface (1) with at least one nickel layer (2); and
c) carrying out at least one second electrodeposition in order to coat, at least partially, the section of metal surface (1) provided with said nickel layer (2) with at least one silver layer (4, 3).

According to the invention, this process furthermore consists in:
d) subjecting said metal surface (1) coated with the nickel layer (2) and the one or more silver layers (4, 3) to at least one cleaning operation of chemical and/or electrolytic nature, and optionally to a drying operation. In addition, the first and second electrodeposition operations (steps b) and c)) are configured and parameterized to form a nickel layer of at least 0.7 µm thickness and a silver layer of thickness comprised between 2 µm and 10 µm and preferably between 2 µm and 5 µm, respectively.

By virtue of the aforementioned combined technical provisions, the invention allows a treated metal surface (1) to be formed that exhibits, over the long term, a high reflectance (of about 90%) with respect to blue light, a good solderability and wire bondability, an excellent resistance to corrosion, a substantial absence of migration of the metal from which the substrate (1') is made through the upper layers (2, 4, 3), and no visual defects on the surface (3).

Advantageously, provision is made for the process to consist, furthermore, after step d), in:
e) subjecting said cleaned metal surface (1) coated with the nickel layer (2) and the one or more silver layers (4, 3) to a passivation operation.

The metal surface (1) that is to receive the electrodeposits may be any metal less electropositive than silver, including iron, tin, nickel or copper, and alloys based on these metals.

In one preferred embodiment, the material from which the metal surface (1) of the substrate (1') is made is copper or a copper alloy, said metal surface (1) corresponding to the surface of a substrate (1') made of copper or of a copper alloy (i.e. made entirely of copper or alloy), or consisting of an electrodeposit of copper or of a copper alloy on a substrate (1') made of a different alloy or metal or made of a plastic (or comprising plastic zones).

Very advantageously, the metal surface (1) corresponds to the surface, optionally added in the form of an electrodeposit, of a substrate (1') taking the form of a foil. The substrate (1') may thus take the form of a metal foil or a metal-plastic foil.

In this case, at least the electrodeposition steps and preferably all the treatment steps may advantageously be carried out continuously, preferably from roll to roll, by moving said foil (1'). The continuous treatment of the substrate (1') is thus an industrially advantageous and economical process since it permits high production rates.

In another embodiment, the metal surface (1) that is to receive an electrodeposit may have a complex shape, with narrow or wide selective electrodeposition zones and/or reliefs (cavities and/or bumps and/or holes).

Preferably, before placing the surface of the substrate (1') into contact with the electrodeposition baths, the metal surface (1) is cleaned.

Thus, more precisely, provision may be made, before the nickel layer (2) is applied by electrodeposition, for the metal surface (1) to be subjected to an operation in which it is cleaned, preferably by means of an alkaline cleaning product. Said metal surface (1) may optionally also be subjected to a micro-etch, in the preparation step.

In the case of copper or a copper alloy, the etch is carried out in an acid bath. In one preferred embodiment, the micro-etch bath contains sulfuric acid and sodium persulfate.

Advantageously, the first electrodeposit is nickel, this metal species both forming a barrier to the diffusion of copper toward the surface and participating in the increase of the reflectance of the final layer. The matte or semi-bright nickel deposit (2) is preferably produced in a bath containing: i) one or more sources of nickel ions, preferably nickel sulfate and nickel chloride; ii) a complexing agent; iii) an acid; and iiii) at least one additive, such as a brightener and/or a wetting agent, said bath preferably being a Watts bath.

By providing a nickel layer (2) of at least 0.7 µm, the diffusion of copper toward the silver layer (3) is prevented and the reflectance of the silver layer (3) is increased.

Once the surface (1) has received a nickel electrodeposit (2) with a sufficient thickness, the metal surface (1) with the nickel electrodeposit (2) receives a silver electrodeposit, in one or more phases.

The silver bath used to produce the final silver layer (3) is propitious to the deposition of silver by immersion. Such immersion deposition may adversely affect the adhesion of the silver layer (3), and the appearance of this layer, and in addition the reflectance properties.

So as to avoid forming such mediocre quality silver deposits, the surface (1) coated with a nickel electrodeposit (2) may be coated with an intermediate electrodeposit in a silver strike bath, before the definitive or final silver electrodeposition.

More precisely, the process may consist, after the nickel electrodeposit (2) has been formed, in forming an additional intermediate electrodeposit (4) by means of a prior pre-silvering or strike bath, so as to form a silver primer layer (4). Said bath advantageously contains 3 to 10 grams of silver ions, advantageously originating from silver cyanide, per litre of solution and 40 to 80 grams of cyanide ions, originating from potassium cyanide, per litre of solution.

This prior silvering operation resulting in the layer (4), despite the advantages thereof, nevertheless remains optional.

Regarding the single or final (depending on whether or not the prior silvering step is carried out) silver electrodeposition step, in order to ensure a maximum reflectance it is carried out via a specific bath. Provision is made for the bath employed to contain at least:
a) a soluble source of silver ions;
b) cyanide; and
c) a brightener additive.

Advantageously, the soluble source of silver ions is a compound of cyanide and silver for example including silver cyanide, sodium and silver cyanide, potassium and silver cyanide or a combination of these salts.

In one preferred embodiment, the source of silver ions may be silver cyanide or potassium-silver cyanide. In one more preferred embodiment, the source of silver ions is silver cyanide. The concentration of silver in the electrodeposition solution is comprised between 40 and 120 grams per litre, and is preferably located in the range of 60 to 100 grams per litre.

Since it is not a question of a spot plating technology, the concentration of the cyanide must be higher than the concentration of silver ions in order to ensure a good complexation. The concentration of the cyanide must therefore be comprised between 35 and 100 grams per litre, but is preferably located in the range of 50 to 80 grams per litre. The concentration of the cyanide may be adjusted with potassium or sodium cyanide.

The silver electrodeposition solution also contains a brightener agent. It is known by those skilled in the art that the addition of small quantities of divalent or tetravalent selenium to silver electrolytic baths improves brightness. The bath of the invention contains between 0.05 and 2.8 milligrams per litre of selenium and preferably between 0.09 and 0.5 milligrams per litre. Suitable selenium compounds include selenides of alkali metals, selenocyanate, and many organic selenium compounds. In one preferred embodiment, the brightener is sodium or potassium selenocyanate and preferably potassium selenocyanate.

In summary, the silver electrodeposition bath preferably contains:
- silver ions, namely 40 to 120 grams per litre and preferably 60 to 100 grams per litre, originating from silver cyanide or potassium-silver cyanide;
- cyanide ions, namely 35 to 100 grams per litre and preferably 50 to 80 grams per litre, originating from potassium or sodium cyanide; and
- selenium ions, namely 0.05 to 2.8 milligrams per litre of selenium and preferably 0.09 to 0.5 milligrams per litre, originating from tetravalent or divalent selenium compounds, preferably sodium and potassium selenocyanate and more preferably potassium selenocyanate.

The pH of the solution of the bath advantageously is comprised between 11 and 13.

The silver bath, for producing the single or final silver deposit, is conventionally maintained at a temperature of about 40°C to about 70°C and preferably of about 50°C to about 60°C, and the single and/or final electrodeposition is then carried out at this temperature (the pre-silvering phase being carried out at room temperature).

The metal foil (1') that is to receive an electrodeposition is submerged in the electrodeposition solution and connected to a generator of electric current for a suitable length of time to achieve the electrodeposition thickness desired for the deposit in question. The current density to be used is located in the range 1 A/dm² to 35 A/dm² and preferably in the range 5 A/dm² to 20 A/dm².

The silver electrodeposition thickness is, in accordance with the invention, comprised between 2 and 10 µm and preferably between 2 and 5 µm in order to obtain a good reflectance and a good solderability, adhesive bondability and wire bondability.

The nickel layer and the silver layer may extend either over only one portion of the metal surface (1), or over the entirety of this surface.

In accordance with another important aspect of the invention, a step of cleaning and passivating are provided after the step of depositing the new silver layer 3.

Specifically, under certain circumstances and with certain types of surfaces (1), visual defects may form. Thus, brown spots (silver sulfides) may appear after treatment on the layer (3), because of the presence of residues of the electrolytic bath. In the case of a substrate (1) containing plastic portions, in particular of the epoxy type, yellowing of these portions may also occur.

Apart from causing the surface to deteriorate during ageing, such defects may have an impact on the appearance of the surface and may be critical with respect to the connection, electrical-conduction or reflectance properties.

The formation of such spots and the yellowing may be prevented, according to the observations of the inventors, by implementing a cleaning operation in an acid or alkaline (for example electrolytic or chemical) cleaning bath.

In one embodiment, the invention uses an acid chemical cleaning bath containing 30% hydrochloric acid.

In another embodiment, an electrolytic alkaline cleaning bath is employed, which advantageously contains:
- sodium hydroxide: 30 to 80 millilitres per litre and preferably 40 to 60 millilitres per litre;
- sodium carbonate: 3 to 8 grams per litre and preferably 4 to 7.5 grams per litre; and
- sodium tetraborate: 0.6 to 1.6 grams per litre and preferably 0.8 to 1.5 grams per litre.

This alkaline bath is maintained at a temperature between 15°C and 45°C and preferably at about 25°C.

The current density used is in the range 1 A/dm² to 20 A/dm² and preferably in the range 5 A/dm² to 15 A/dm².

In order to prevent any other degradation of the surface (3), the inventors have discovered that it is advantageous to add a passivation step. A metal-type passivation allows the connectivity properties of the surface to be preserved.

According to the investigations of the inventors, this last treatment may be carried out in a preferably alkaline passivation bath that contains:
- sodium hydroxide: 4 to 45 millilitres per litre and preferably 8 to 30 millilitres per litre; and
- potassium stannate: 0.5 to 6 grams per litre and preferably 1 to 4 grams per litre.

This alkaline bath is maintained at room temperature and may be used with or without passage of a current. In the case of an operation with current, the current density used is in the range 0.5 A/dm² to 1 A/dm².

The immersion of the cleaned surface (1), coated with the layers (2), (4) and (3), into this bath prevents the formation of silver sulfides even after immersion in a concentrated alkali-metal-sulfide solution. In addition, this passivation is able to resist a temperature of 300°C for up to 10 minutes: the properties of the surface are therefore preserved in case of heating.

A practical nonlimiting example of the process of the invention is given below. This example also presents the evaluation of the properties of the samples obtained.

Electrodeposits of nickel and silver were produced on a copper substrate using the following baths under the following electrodeposition conditions. The metal surface (1) was prepared beforehand using the process detailed above.

The table below details the nickel electrodeposition bath used:

| | |
|---|---|
| Nickel ions | 110 g/L (using nickel sulfate and nickel chloride) |
| Boric acid | 50 g/L |
| Brightener | 20 mL/L |
| Wetting agent | 1 mL/L |
| Temperature | 60°C |
| Current density | 3 A/dm² |

The table below details the silver electrodeposition bath used:

| | |
|---|---|
| Silver ions | 70 g/L (using silver cyanide) |
| Free cyanide ions | 60 g/L (using potassium cyanide) |
| Potassium selenocyanate | 0.16 mg/L |
| Temperature | 60°C |
| Current density | 3 A/dm² |

The metal surface obtained was then cleaned using the alkaline bath and passivated using the metal passivation bath described above.

Next, the performance of the silver electrodeposit was evaluated on samples produced according to the invention.

The aptitude for connection of components by soldering was tested via the wetting-balance or "meniscograph" method. The wetting-balance test is used to quantify the wetting affinity between a molten solder and the surface subjected to the test. It measures the time required for the solder to wet the surface, called the zero time, and the contact angle between the solder and the surface.

Measurements were taken using the ST60 meniscograph machine from Metronelec. Samples were first submerged into a flux in order to facilitate wetting by the solder.

The table below summarizes the conditions of the wetting-balance test:

| Wetting-balance machine | Meniscograph ST60 |
|---|---|
| Solder composition | Sn 96.4% Cu 0.4% Ag 3.2% |
| Solder temperature | 245°C |
| Time of immersion in the solder | 10 s |
| Immersion depth | 5 mm |
| Sample dimensions | 20 × 10 × 0.1 mm |
| Type of flux | Non-activated soldering flux (445 mN/m) |

The table below gives the results of the solderability tests:

| Solderability test measurements | |
|---|---|
| Final contact angle | Zero time |
| 31.7° | 3.81 s |

The solderability results are good and guarantee that it is possible to solder components to surfaces treated using the process according to the invention.

Wire bondability was then evaluated with aluminium wires of 200 µm and gold wires of 25 µm, using a wedge bonder.

The table below collates the aluminium-wire bonding conditions:

| Wire-bonding machine | Orthodyne model 20 |
|---|---|
| Wire | Aluminium, 8 mils (203.2 µm) |
| First weld | Time => 100 ms |
| | Power => 140 |
| Second weld | Time => 100 ms |
| | Power => 160 |

The table below collates the gold-wire bonding conditions:

| Wire-bonding machine | Kulicke & Soffa, model KS 4523 |
|---|---|
| Wire | Gold, 25 µm |
| Platen temperature | 150°C |
| First weld | Time => 3 ms |
| | Force => 3 |
| | Power => 2.3 |
| Second weld | Time => 3 ms |
| | Force => 2 |
| | Power => 4.4 |

The wire bonds obtained were shear and pull tested. The results obtained are as follows:

| | Bonding test measurements | | | |
|---|---|---|---|---|
| | Without passivation | | With passivation | |
| | Pull test | Shear test | Pull test | Shear test |
| Aluminium wire | 363 gf | 267 gf | 262 gf | 131 gf |

| | Pull test with and without passivation | |
|---|---|---|
| | Without passivation | With passivation |
| Gold wire | 19.52 gf | 13.38 gf |

These results are very satisfactory and according to standard MIL-STD-883 allow these two types of wire to be bonded between the chip and the obtained surface with a good reliability.

The reflectance performance of the samples was also evaluated. Two types of equipment were used, a spectrophotometer (model Ci6X from Xrite) and a densitometer (model ND11 from Nippon Denshoku). The spectrophotometer was able to measure reflectance at a precise wavelength and the densitometer was able to measure reflectance in a wavelength range.

The table below indicates the average measured values:

| | Spectrophotometer (450 nm) | Densitometer (380-430 nm) |
|---|---|---|
| Reflectance value | 94% | 87% |

The invention also relates to a metallized or metal foil obtained by means of the process described above and comprising at least, in succession, a copper layer (1, 1'), a nickel layer (2) and a silver layer (4, 3), foil characterized in that the nickel layer (2) has a thickness of at least 0.7 µm and in that the silver layer (4, 3) has a thickness comprised between 2 µm and 10 µm and preferably between 2 µm and 5 µm.

By virtue of the provisions of the invention, it is therefore possible to provide an industrial process (comprising at least steps a) to d) and preferably steps a) to e)) for continuously treating a substrate made of copper, or coated with copper, with as end result the obtainment of a high reflectance in the blue-light domain, a good wire bondability and solderability or adhesive bondability and an excellent resistance to corrosion and to diffusion. In order to arrive thereat, the substrate according to the invention is in succession degreased, micro-etched, coated with nickel, coated with silver, cleaned and passivated. The preferred version of the process allows a surface with a reflectance higher than 90% in the wavelength domain 380-450 nm to be obtained, this surface being able to prevent diffusion of copper from the substrate to the surface, resisting corrosion and being able to receive components by means of soldering or connections via aluminium or gold wire bonding. All of these obtained properties do not change over time - the performance obtained is stable.

The resulting surface is in particular excellent for light-emitting-diode applications.

Of course, the invention is not limited to the embodiment described and shown in the appended drawings. Modifications remain possible, in particular from the point of view of the constitution of the various elements or of substitution with equivalents, without however departing from the scope of protection of the invention.

## Claims

1. Process for treating a metal surface, essentially comprising the following successive steps consisting in:
a) preparing the metal substrate (1') in order to make the surface (1) apt to receive an electrodeposit of at least one other metal, said surface preparation optionally being specifically suitable for receiving a nickel electrodeposit;
b) carrying out at least one first electrodeposition in order to coat at least one section of the metal surface (1) with at least one nickel layer (2); and
c) carrying out at least one second electrodeposition in order to coat, at least partially, the section of metal surface (1) provided with said nickel layer (2) with at least one silver layer (4, 3);
process **characterized in that** it consists in:
d) subjecting said metal surface (1) coated with the nickel layer (2) and the one or more silver layers (4, 3) to at least one cleaning operation of chemical and/or electrolytic nature, and optionally to a drying operation; and
**in that** the first and second electrodeposition operations are configured and parameterized to form a nickel layer (2) of at least 0.7 µm thickness and a silver layer (4, 3) of thickness comprised between 2 µm and 10 µm and preferably between 2 µm and 5 µm, respectively.

2. Process according to Claim 1, **characterized in that** it consists, furthermore, after step d), in:
e) subjecting said cleaned metal surface (1) coated with the nickel layer (2) and the one or more silver layers (4, 3) to a passivation operation.

3. Process according to Claim 1 or 2, **characterized in that** the material from which the metal surface (1) of the substrate (1') is made is copper or a copper alloy, said metal surface (1) corresponding to the surface of a substrate (1') made of copper or of a copper alloy, or consisting of an electrodeposit of copper or of a copper alloy on a substrate (1') made of a different alloy or metal or made of a plastic.

4. Process according to either one of Claims 1 and 2, **characterized in that** the metal surface (1) corresponds to the surface, optionally added in the form of an electrodeposit, of a substrate (1') taking the form of a foil, and **in that** at least the electrodeposition steps and preferably all the treatment steps are carried out continuously, by moving said foil (1'), preferably from roll to roll.

5. Process according to any one of Claims 1 to 4, **characterized in that**, before the nickel layer (2) is applied by electrodeposition, the metal surface (1) is subjected to a cleaning operation, preferably by means of an alkaline cleaning product, said metal surface (1) possibly optionally also being subjected to a micro-etch, for example in an acid bath, in the preparation step.

6. Process according to any one of Claims 1 to 5, **characterized in that** the nickel electrodeposit, which is matte or semi-bright, is produced in a bath containing: i) one or more sources of nickel ions, preferably nickel sulfate or nickel chloride; ii) a complexing agent; iii) an acid; and iiii) at least one additive, such as a brightener and/or a wetting agent, said bath preferably being a Watts bath.

7. Process according to any one of Claims 1 to 6, **characterized in that** it consists, after the nickel electrodeposit has been formed and before the definitive silver electrodeposition, in forming an additional intermediate electrodeposit, by means of a prior pre-silvering or silver strike bath, said bath advantageously containing 3 to 10 grams of silver ions, advantageously originating from silver cyanide, per litre of solution and 40 to 80 grams of cyanide ions, originating from potassium cyanide, per litre of solution, so as to form a silver primer layer (4).

8. Process according to any one of Claims 1 to 7, **characterized in that** the bath for the electrodeposition of the single or final silver layer (3) contains at least:
a) a soluble source of silver ions;
b) cyanide; and
c) a brightener additive.

9. Process according to any one of Claims 1 to 8, **characterized in that** the silver electrodeposition bath contains:
- silver ions, namely 40 to 120 grams per litre and preferably 60 to 100 grams per litre, originating from silver cyanide or potassium-silver cyanide;
- cyanide ions, namely 35 to 100 grams per litre and preferably 50 to 80 grams per litre, originating from potassium or sodium cyanide; and
- selenium ions, namely 0.05 to 2.8 milligrams per litre of selenium and preferably 0.09 to 0.5 milligrams per litre, originating from tetravalent or divalent selenium compounds, preferably sodium and potassium selenocyanate and more preferably potassium selenocyanate,
the pH of the solution of the bath advantageously being comprised between 11 and 13.

10. Process according to any one of Claims 1 to 9, **characterized in that** the final or single silver electrodeposition is carried out at a temperature comprised between 40°C and 70°C and preferably of about 50°C to about 60°C, and with a current density in the range 1 A/dm² to 35 A/dm² and preferably in the range 5 A/dm² to 20 A/dm².

11. Process according to any one of Claims 1 to 10, **characterized in that** the final cleaning operation is carried out in an alkaline or acid cleaning bath.

12. Process according to Claim 11, **characterized in that** the solution of the cleaning bath contains the following compounds:
- sodium hydroxide, in an amount of 30 to 80 millilitres per litre and preferably 40 to 60 millilitres per litre;
- sodium carbonate, in an amount of 3 to 8 grams per litre and preferably 4 to 7.5 grams per litre; and
- sodium tetraborate, in an amount of 0.6 to 1.6 grams per litre and preferably 0.8 to 1.5 grams per litre.

13. Process according to Claim 11 or 12, **characterized in that** the cleaning operation is carried out at a temperature between about 15°C and about 45°C and preferably at about 25°C, with a current density in the range 1 A/dm² to 20 A/dm² and preferably in the range 5 A/dm² to 15 A/dm².

14. Process according to Claim 2, **characterized in that** the final passivation operation is carried out in a metal passivation bath.

15. Process according to Claim 14, **characterized in that** the solution of the passivation bath contains the following compounds:
- sodium hydroxide, in an amount of 4 to 45 millilitres per litre and preferably 8 to 30 millilitres per litre; and
- potassium stannate, in an amount of 0.5 to 6 grams per litre and preferably 1 to 4 grams per litre.

16. Process according to Claim 14 or 15, **characterized in that** the passivation operation is carried out at room temperature, with or without passage of a current.

17. Process according to Claim 16, **characterized in that** the passivation is carried out in cathodic mode with a current density in the range 0.5 A/dm² to 1 A/dm².

18. Metallized or metal foil obtained by means of the process according to any one of Claims 1 to 17 and comprising at least, in succession, a copper layer (1, 1'), a nickel layer (2) and a silver layer (4, 3), foil **characterized in that** the nickel layer (2) has a thickness of at least 0.7 µm and **in that** the silver layer (4, 3) has a thickness comprised between 2 µm and 10 µm and preferably between 2 µm and 5 µm.
